# FASCICULE DE BREVET EUROPEEN

(11) **EP 3 900 017 B1**
(45) Date de publication et mention de la délivrance du brevet: **26.10.2022**
(21) Numéro de dépôt: 19835459.9
(22) Date de dépôt: 29.11.2019
(51) Int. Cl.: H01L 21/02, H01L 21/18, H01L 21/762, H01L 33/00, H01L 33/12

(54) **PROCEDE DE FABRICATION D'UN SUBSTRAT DE CROISSANCE**
VERFAHREN ZUR HERSTELLUNG EINES WACHSTUMSSUBSTRATS
METHOD FOR MANUFACTURING A GROWTH SUBSTRATE

(30) Priorité: 21.12.2018 FR 1873889
(43) Date de publication de la demande: 27.10.2021
(73) Titulaire: SOITEC, 38190 Bernin (FR)
(72) Inventeur: BETHOUX, Jean-Marc, 38500 LA BUISSE (FR); ROZHAVSKAIA, Mariia, 38000 GRENOBLE (FR)
(74) Mandataire: IP Trust
(86) Numéro de dépôt international: PCT/FR2019/052855
(87) Numéro de publication internationale: WO 2020/128184

(56) Documents cités:
- WO-A1-2018/158529

## Description

### DOMAINE DE L'INVENTION

La présente invention concerne un substrat pour la croissance d'une structure semi-conductrice et un procédé de fabrication d'un tel substrat.

### ARRIERE PLAN TECHNOLOGIQUE DE L'INVENTION

On connaît des documents EP2151852 ou EP2151856 des procédés de fabrication visant à former sur un support des îlots de croissance d'InGaN cristallin au moins partiellement relaxés. Les îlots de croissance présentent une concentration d'indium comprise entre 5 et 7% pour une épaisseur d'environ 100nm.

Ces méthodes comprennent tout d'abord la préparation d'un substrat donneur comportant une couche superficielle d'InGaN, contrainte en compression, disposée sur une couche germe de GaN formé sur un support donneur. On reporte ensuite une partie au moins de la couche superficielle sur un substrat de relaxation, en intercalant une couche de fluage entre la couche d'InGaN reportée et le substrat de relaxation. Selon ces méthodes, on définit des îlots de croissance dans la couche superficielle et on applique un traitement thermique pour relaxer au moins en partie ces îlots.

À l'issue de ce procédé, les îlots de croissance en InGaN présentent un paramètre de maille adapté à la croissance d'une structure optoélectronique semi-conductrice, ce paramètre de maille ne pouvant être fourni par un matériau massif, en volume et pour un coût raisonnable. La structure semi-conductrice peut par exemple correspondre à une diode électroluminescente (LED), une diode laser, une cellule photovoltaïque.

Une telle structure optoélectronique semi-conductrice, par exemple une diode électroluminescente (LED), comprend un empilement de couches semi-conductrices cristallines, dont au moins une couche active, c'est-à-dire une couche présentant des propriétés optoélectroniques. Une couche active de LED peut comprendre, comme cela est bien connu en soi, une alternance répétée d'une couche barrière et d'une couche formant un puits quantique. La teneur en indium d'une couche de puits quantique en InGaN peut être de l'ordre de 10 % pour former des diodes émettant dans le bleu, supérieure à environ 20 % lorsque la diode émet dans le vert, supérieure à environ 40 % pour une diode émettant dans le rouge. La couche barrière comprend une teneur en indium inférieure à celle de la couche de puits quantique.

Plus la teneur en indium est importante, plus le paramètre de maille naturel (c'est-à-dire celui d'une couche qui serait parfaitement relaxée) de la couche de puits quantique est important. Dit autrement, plus la teneur en indium est importante plus la couche de puits quantique est mise en contrainte compressive lorsqu'elle est formée sur un support de croissance présentant un paramètre de maille déterminé.

Un excès de contraintes dans l'empilement formant une structure optoélectronique peut conduire à former une structure défectueuse. Cette contrainte peut notamment être à l'origine de dislocations ou de défauts pyramidaux (désignés « V-pits » dans la littérature anglo-saxonne de ce domaine) se formant à la surface des films d'InGaN. Ces défauts détériorent les performances fonctionnelles de la structure optoélectronique.

L'apparition de défauts pyramidaux lors de l'épitaxie d'un film d'InGaN est largement documentée, par exemple par l'article de Jahnen, B. et al. "Pinholes, dislocations and strain relaxation in InGaN." Materials Research Society Internet Journal of Nitride Semiconductor Research 3 (1998) mais n'est pas encore complètement comprise.

Elle ne peut notamment pas être assimilée à une transition de mode de croissance de type Stranski-Krastanov ou Volmer-Weber. Elle s'opère au niveau de l'émergence de dislocations traversantes dont le vecteur de Burger a une composante suivant l'axe c. L'épaisseur critique de films d'InGaN à partir de laquelle se développent ces défauts pyramidaux décroît très rapidement avec la concentration en Indium. Elle est d'environ 150nm pour des compositions inférieures ou égales à 10% en Indium et d'à peine une cinquantaine de nanomètres pour 15% en Indium.

Pour pouvoir réaliser des diodes électroluminescentes aptes à émettre dans le domaine du rouge ou du vert ou s'en approchant, il serait souhaitable de disposer d'un substrat « à îlots », ces îlots de croissance présentant un paramètre de maille s'approchant du paramètre de maille naturel d'une couche d'InGaN présentant une proportion d'indium d'environ 40%, par exemple compris entre 34% et 43%. Ce paramètre de maille pourrait dans ce cas être compris entre 0,331 et 0,334 nanomètre. D'une manière plus générale, il serait souhaitable de disposer d'un substrat « à îlots », les îlots de croissance présentant une bonne qualité cristalline et un paramètre de maille qui puisse être choisi dans une gamme très large, comprise par exemple entre 0,321 et 0,337 nm, correspondant au paramètre de maille d'un matériau entièrement relaxé d'InGaN comprenant une proportion d'indium compris entre environ 6% et 50%. On pourrait alors choisir librement le paramètre de maille des îlots de croissance pour qu'il soit accordé aux paramètres de maille des différentes natures de couches composant l'empilement formant la structure optoélectronique, et notamment au paramètre de maille des couches de puits quantique d'une couche active de LED.

La méthode de relaxation présentée en introduction présente toutefois des limitations qui ne permettent pas de répondre parfaitement à ce besoin.

D'une part, pour les raisons évoquées précédemment, il est difficile de préparer un substrat donneur comprenant une couche superficielle d'InGaN de bonne qualité cristalline comprenant une forte proportion en indium, par exemple supérieure à 5% ou 7%. Cela est d'autant plus vrai que la couche superficielle est épaisse.

D'autre part, la relaxation des îlots de croissance est souvent partielle, typiquement comprise entre 50% et 90% de son potentiel. L'expérience montre que ce degré de relaxation est notamment déterminé par l'épaisseur des îlots, plus cette épaisseur est importante, plus le degré de relaxation peut être élevé.

En conséquence, les îlots d'InGaN d'un substrat « à îlots » sont en contrainte compressive et leurs paramètres de maille sont plus petits que le paramètre de maille d'une couche en InGaN de même proportion d'indium qui serait parfaitement relaxée.

On pourrait chercher à compenser cela en augmentant la teneur d'indium dans la couche superficielle contrainte du substrat donneur et/ou en augmentant l'épaisseur de cette couche. Mais, comme on l'a vu, la croissance d'une couche superficielle présentant une forte proportion d'indium et/ou une épaisseur importante tend à la formation de défauts pyramidaux qui peuvent la rendre inapte à son utilisation.

Pour former une couche superficielle d'InGaN de bonne qualité, on choisit généralement une teneur en indium comprise entre 5 et 7% pour former une couche de 200nm environ. Ces caractéristiques ne sont pas suffisantes.

Le document WO2018158529 divulgue un procédé permettant de choisir le paramètre de maille des îlots de croissance d'InGaN, mais ce procédé est particulièrement complexe à mettre en œuvre.

Dans la pratique, il est donc difficile d'obtenir un substrat à îlot pour la croissance d'une structure optoélectronique semi-conductrice présentant un paramètre de maille excédant 0,321 nm (correspondant au paramètre de maille d'un îlot d'InGaN relaxé à 90% et comprenant 7% d'indium) ou excédant 0,322 nm (correspondant au paramètre de maille d'un îlot d'InGaN relaxé à 90% et comprenant 10% d'indium) et présentant une bonne qualité cristalline, c'est-à-dire avec suffisamment peu de défauts pyramidaux.

La présente invention vise à résoudre au moins partiellement ce problème.

### BREVE DESCRIPTION DE L'INVENTION

En vue de la réalisation de ce but, l'objet de l'invention propose un procédé de fabrication d'un substrat de croissance comprenant les étapes suivantes :
- préparer un substrat donneur en formant une couche superficielle semi-conductrice cristalline sur une couche germe d'un support donneur ;
- reporter au moins une partie de la couche superficielle sur un substrat de relaxation, en intercalant une couche de fluage entre le substrat donneur et le substrat de relaxation pour former une structure de relaxation ;

- définir des îlots de croissance dans la couche superficielle ;
- traiter thermiquement la structure de relaxation pour relaxer au moins en partie les îlots de croissance ;
- le procédé étant caractérisé en ce que la préparation du substrat donneur comprend la formation de la couche superficielle comme une pluralité d'alternances d'une couche primaire d'InGaN et d'une couche secondaire d'AlGaN, la concentration en indium et l'épaisseur des couches primaires et la concentration en aluminium et l'épaisseur des couches secondaires étant choisis pour qu'une couche homogène d'AlInGaN équivalente, en concentration d'aluminium et d'indium, à la couche superficielle présente un paramètre de maille naturel différent du paramètre de maille de la couche germe 2a.

En réalisant le substrat donneur selon le procédé qui vient d'être décrit, on peut former une couche superficielle d'AlInGaN épaisse, de l'ordre de 200 nm ou plus, et présentant un paramètre de maille naturel équivalent à celui d'une couche d'InGaN avec une forte proportion d'indium, sans que la couche superficielle ne présente une densité excessive de défauts pyramidaux.

Selon d'autres caractéristiques avantageuses et non limitatives de l'invention, prises seules ou selon toute combinaison techniquement réalisable :
- chaque couche primaire présente une concentration en indium strictement supérieure à 0% et inférieure ou égale à 50% et dont l'épaisseur est comprise entre 10 et 150 nm ;
- chaque couche secondaire présente une concentration d'aluminium supérieure à 0% et inférieure ou égale 20% et dont l'épaisseur est comprise entre 2 et 15 nm ;
- la pluralité d'alternances comprend entre 2 et 20 alternances ;
- la couche superficielle présente une épaisseur supérieure à 200nm ;
- Le procédé comprend un traitement thermique d'homogénéisation de la couche superficielle ;
- Le procédé comprend le report des îlots de croissance sur un support final, une couche diélectrique étant intercalée entre les îlots de croissance et le support final.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1] La figure 1 représente un substrat donneur conforme à l'invention ;
[Fig. 2a] La figure 2a représente une première étape d'un procédé de fabrication d'un substrat donneur ;
[Fig. 2b] La figure 2b représente une autre étape d'un procédé de fabrication d'un substrat donneur ;
[Fig. 2c] La figure 2a représente une deuxième étape d'un procédé de fabrication d'un substrat donneur.

### DESCRIPTION DETAILLEE DE L'INVENTION

Dans la présente description, on vise à préparer un substrat donneur comportant une couche superficielle présentant un paramètre de maille naturel compris entre 0,321 et 0,337 nm, d'épaisseur supérieure à 100nm ou 200nm et peu susceptible de former une densité excessive de défauts, notamment des défauts de type V-pits. En prenant l'hypothèse d'une relaxation complète, ce qui peut être approché lorsque la couche est épaisse, une telle couche peut permettre de former des îlots de croissance présentant un paramètre de maille compris entre 0,321 et 0,337 nm.

Par souci d'exhaustivité, on rappelle un exemple de mise en œuvre du procédé de relaxation pouvant tirer profit d'un tel substrat donneur. Après avoir formé le substrat donneur dont on donnera les caractéristiques dans une section suivante de cette description, on reporte une couche superficielle de ce substrat sur un substrat de relaxation. Une couche de fluage, par exemple en BPSG, est intercalée entre le substrat de relaxation et le substrat donneur. Le report peut être obtenu, par collage du substrat donneur au substrat de relaxation et par amincissement et/ou fracture du substrat donneur. On définit ensuite une pluralité d'îlots de croissance dans la couche superficielle transférée, puis on traite thermiquement le substrat de relaxation, la couche de fluage et les îlots à une température supérieure à la température de transition visqueuse de la couche de fluage, ce qui conduit à la relaxation au moins partielle de la pluralité d'îlots de croissance. Par « pluralité d'îlots », on désigne un film formé d'un ensemble de zones indépendantes et non jointives, ces zones pouvant être délimitées par des tranchées exposant la couche de fluage ou le support de relaxation. Les îlots peuvent tous présenter des tailles et/ou des formes identiques ou différentes entre elles, et présenter une dimension principale dans le plan défini par le substrat de relaxation (diamètre ou longueur selon la forme de l'îlot) comprise entre quelques microns et 1 mm. Les îlots peuvent être séparés les uns des autres par des tranchées dont la largeur peut être comprise entre 1 et 50 microns.

Le degré de relaxation obtenu à l'issue du traitement thermique de relaxation peut atteindre 50% à 90% du degré de relaxation maximal correspondant à l'obtention d'une couche parfaitement relaxée. Ce degré de relaxation est notamment dépendant de l'épaisseur des îlots, de la durée et de l'amplitude du traitement thermique.

Pour assister cette relaxation et éviter un phénomène de gauchissement des îlots de croissance au cours de la déformation plastique qui s'opère au cours de la relaxation, il peut être prévu de former une couche raidisseur sur les îlots, avant l'application du traitement thermique de relaxation. Le degré de relaxation d'un îlot obtenu après cette étape de traitement thermique est celui qui équilibre les contraintes présentes dans la couche raidisseur et dans l'îlot. On note que la couche raidisseur peut être formée (ou comprendre) d'un résidu du substrat donneur qui aurait été préservé sur la couche contrainte à l'issue de son transfert sur la couche de fluage.

Les îlots de croissance peuvent être définis dans la couche semi-conductrice après que celle-ci ait été reportée sur le substrat de relaxation, comme cela a été décrit ci-dessus, mais alternativement, on pourrait prévoir que les îlots de croissance soient définis directement dans le substrat donneur, avant leurs reports sur le substrat de relaxation.

Les îlots de croissance au moins partiellement relaxés peuvent être transférés collectivement sur un support final pour constituer un substrat de croissance, à l'aide d'une technique de transfert de couche comprenant par exemple le collage de la face exposée des îlots sur le support final et le retrait du substrat de relaxation et de la couche de fluage. Une couche de collage, comprenant par exemple au moins une couche diélectrique, peut être prévue entre les îlots et le support final, pour faciliter leur assemblage.

Le substrat de croissance peut alors être utilisé pour former des structures optoélectroniques semi-conductrices, comme cela a été rappelé en introduction de cette demande.

Selon une variante d'application particulièrement intéressante, le substrat de croissance peut servir de support d'un substrat donneur, et donc apte à recevoir une nouvelle couche superficielle contrainte. On peut alors appliquer à nouveau, en récurrence, le procédé de relaxation sur cette nouvelle couche superficielle.

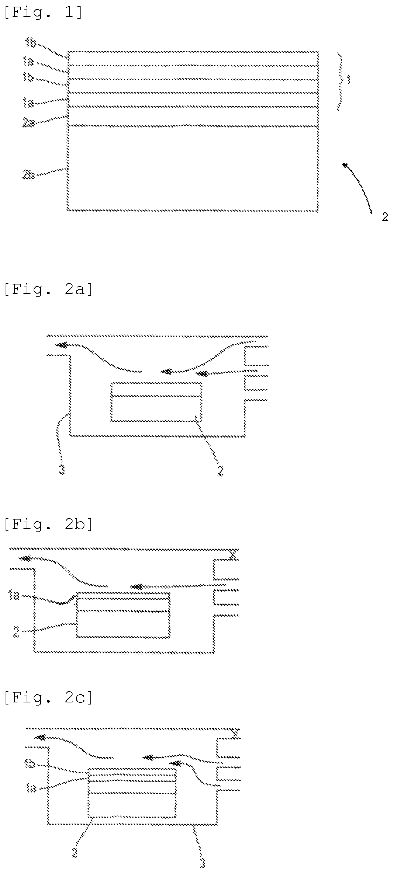

La figure 1 représente un substrat donneur 2 conforme à l'invention comprenant une couche superficielle semi-conductrice cristalline 1 dont la composition est de formule générale (Al,In,Ga)N. Par AlInGaN on désigne une couche monocristalline (i.e. obtenue par croissance épitaxiale) formée d'espèces atomiques d'aluminium, d'indium, de gallium et d'azote, les proportions respectives x et y d'aluminium et d'indium venant en complément de la proportion 1-x-y de gallium pour constituer la couche. D'une manière générale, les valeurs x, y et 1-x-y sont comprise dans l'intervalle [0,1].

Le substrat donneur 2 présente une surface de germination adaptée pour recevoir la couche d'AlInGaN 1. Cette surface peut être celle d'une couche germe 2a formée sur un support 2b. Le support 2b peut être constitué d'une plaquette par exemple de saphir, de silicium ou de carbure de silicium, et présente une épaisseur suffisante, typiquement entre 300 et 600 microns, pour fournir la tenue mécanique à l'empilement formé au moins de la couche germe 2a et de la couche semi-conductrice 1.

Selon une première approche, la couche germe 2a peut être un film de GaN formé par croissance épitaxiale sur le support 2b, et présenter une épaisseur comprise entre 2 et 5 microns. Plus généralement, la couche germe 2a peut comprendre un empilement de films élémentaires de GaN et/ou d'AlGaN et dont la composition en aluminium varie d'un film élémentaire à l'autre. De préférence, la couche de germination ou le film élémentaire fournissant la surface de germination présente un paramètre de maille dans le plan a égal à 3,189 Angström, à 0,005 Angström près.

Selon une autre approche, déjà évoqué dans un passage précédent, la couche germe 2a peut être une couche partiellement relaxée d'InGaN, continue ou sous forme d'îlots, obtenue à l'issue du procédé de relaxation précédemment décrit. Le paramètre de maille de maille est de l'ordre de 0,320 nm lorsque la couche d'InGaN présente une épaisseur de l'ordre de 100nm et une concentration en indium inférieure à 5% ou 7%.

Quelle que soit l'approche choisie pour former le substrat donneur 2, la couche semi-conductrice d'AlInGaN 1, disposée sur (et en contact avec) la couche germe 2a, comprend une pluralité d'alternances de couches primaires la et secondaires 1b.

Chaque alternance comprend donc une couche primaire la d'InGaN présentant une composition d'indium strictement supérieur à zéro et inférieur à 50%, et de préférence inférieur à 15%. Son épaisseur est, de préférence, comprise entre 10 et 150 nanomètres. Cette épaisseur est choisie, selon la concentration d'indium qu'elle contient, pour être inférieure à l'épaisseur critique au-delà de laquelle, il y a formation de défauts pyramidaux.

Chaque alternance comprend également, sur et en contact avec la couche primaire la, une couche secondaire 1b de GaN ou d'AlGaN présentant donc une composition en aluminium supérieure ou égale à 0 et, préférentiellement, inférieure ou égale à 10%. Son épaisseur est préférentiellement comprise entre 2 et 15 nanomètres. Cette épaisseur est dans tous les cas choisie inférieure à son épaisseur critique de relaxation dans le plan, par exemple son épaisseur critique de fissuration lorsque la couche secondaire 1b est en tension. Dans un mode de mise en œuvre particulier, la couche secondaire est une couche d'AlGaN et comprend donc une concentration en aluminium strictement supérieure à 0.

Le nombre d'alternances formant la couche semi-conductrice d'AlInGaN 1 est typiquement compris entre 2 et 20. Ce nombre est choisi de manière à conférer à la couche semi-conductrice 1 une épaisseur déterminée. On pourrait notamment imaginer plus de 20 alternances pour former la couche d'AlInGaN 1 très épaisse. Ainsi, on pourra choisir de former une couche semi-conductrice d'AlInGaN 1 présentant une épaisseur supérieure à 100nm, 200nm,500nm, 1000nm ou même supérieure à 1500nm.

Les couches primaires et secondaires la, 1b étant maintenues contraintes, le paramètre de maille de la couche superficielle d'AlInGaN 1 est sensiblement le même que celui de la couche germe 2a, à 0,1 % près. La mesure du paramètre de maille dans le plan pourra se faire par exemple par diffraction des rayons X en incidence rasante.

On note que la couche superficielle d'AlInGaN 1, constituée de la pluralité d'alternances qui vient d'être décrite est équivalente à une couche homogène d'AlInGaN présentant la même épaisseur totale, et la même concentration moyenne (sur toute l'épaisseur de la couche) d'indium, d'aluminium et de gallium. Selon l'invention, on choisit la concentration en indium et l'épaisseur des couches primaires la et également la concentration en aluminium et l'épaisseur des couches secondaires 1b, pour que la couche homogène équivalente d'AlInGaN présente un paramètre de maille naturel (c'est à dire en l'absence de toute contrainte) bien différent du paramètre de maille de la couche germe 2a.

De la sorte, on forme une couche superficielle 1 globalement contrainte, c'est-à-dire que les énergies de contrainte des couches primaires et secondaires formant la couche superficielle ne s'équilibrent pas. Cette contrainte globale peut être libérée au cours des étapes de relaxation du procédé, comme cela a été décrit. Avantageusement, le paramètre de maille libre de la couche homogène équivalente d'AlInGaN est supérieur à celle de la couche germe 2a, de manière à placer la couche superficielle 1 en compression.

On pourra tirer profit de cette contrainte, notamment compressive, dans la suite du procédé de relaxation qui a été décrit pour former des îlots de croissance au moins partiellement relaxés et présentant un paramètre de maille librement choisi.

La composition en indium d'une couche primaire la et en aluminium d'une couche secondaire 1b, ainsi que leurs épaisseurs respectives peuvent varier d'une alternance à l'autre. De manière préférée toutefois, par simplicité de mise en œuvre, on choisira des alternances présentant des couches primaires la et secondaires 1b identiques, notamment pour ce qui concerne la concentration d'indium et d'aluminium.

Comme cela sera exposé plus en détail dans la suite de cet exposé, en relation avec la description détaillée de son procédé de fabrication, la couche semi-conductrice 1 présente une densité de défauts pyramidaux très faible, inférieure ou égale à 10^7 cm^2, voire même à 10^6 par cm^2. De plus, ces défauts présentent une dimension, c'est-à-dire la largeur de l'ouverture au niveau de la surface sur laquelle ils débouchent, inférieure à 200 nm ou 100nm.

La densité et la dimension de défauts pyramidaux peuvent être déterminées par observation d'une portion de surface de la couche semi-conductrice 1, obtenue par exemple par un microscope à force atomique, ou par un microscope à balayage électronique. Sur la portion observée par le microscope, qui peut correspondre à un champ carré de 20 microns de côté par exemple en microscopie à effet de force, on décompte le nombre de défauts visibles présentant une dimension dans le plan d'observation supérieure à 10nm, et que l'on assimilera à des défauts pyramidaux. Le décompte et la dimension du champ sont alors utilisés pour déterminer la densité de défaut.

Par ailleurs, dans le cadre de la présente demande, on considérera qu'une couche ne présente pas de défaut pyramidal, si on ne décompte aucun défaut présentant une dimension dans le plan d'observation supérieure à 10nm, ce plan d'observation présentant une dimension d'au moins 900 µm^2 (par exemple un champ d'observation carré de 30 microns de côté).

Ainsi, l'épaisseur critique de la couche primaire la au-delà de laquelle se forment des défauts pyramidaux peut être facilement établie, pour une concentration d'Indium donnée, en déterminant par l'expérimentation l'épaisseur au-delà de laquelle on observe au moins un défaut pyramidal sur un champ d'observation de 900 µm^2. Des observations similaires de la couche secondaire 1b permettent de déterminer très facilement, pour une concentration d'aluminium donnée, l'épaisseur critique au-delà de laquelle la relaxation de la couche peut conduire à sa fissuration.

Les caractéristiques énoncées de la couche superficielle 1 d'AlInGaN 1 sont remarquables en ce que son épaisseur peut dépasser l'épaisseur critique pour laquelle, pour un film homogène d'InGaN de paramètre de maille naturel similaire, on observerait une densité importante des défauts pyramidaux, présentant généralement une dimension importante supérieure à 200 nm. On peut donc former une couche superficielle 1 susceptible de pouvoir fournir, une fois relaxé, des îlots présentant une bonne qualité cristalline, un paramètre de maille et une épaisseur plus importante que ce qu'il est possible d'obtenir avec une couche superficielle d'InGaN de 100nm et présentant 5 ou 7% d'indium. On pourra notamment choisir les paramètres de la couche superficielle pour que les îlots présentent un paramètre de maille, après le traitement thermique de relaxation, bien compris entre 0,321 et 0,337 nm.

On notera que la diffusion des espèces pouvant se produire entre les couches primaires la et secondaires 2a, ou entre les alternances, peut conduire à altérer les interfaces définissant ces couches. En outre, une exposition de la couche superficielle d'AlInGaN 1 à une température relativement élevée au cours ou à l'issue de sa formation peut favoriser la diffusion de ces espèces et conduire à former une couche 1 homogène en composition. Aussi, une couche superficielle 1 conforme à l'invention peut être homogène en concentration d'aluminium et d'indium et présenter une densité de défauts pyramidaux inférieure ou égale à 10^7 par cm^2 ou à 10^6 par cm^2. Et ces défauts peuvent présenter une dimension inférieure à 100 nm ou 200 nm.

En référence aux figures 2a à 2c, on présente un procédé de réalisation de la couche semi-conductrice d'AlInGaN 1 sur le support donneur 2.

On dispose le support donneur 2 dans une chambre de dépôt d'un bâti d'épitaxie 3, et on forme par épitaxie la couche primaire la d'InGaN à partir de précurseurs comprenant un précurseur d'indium.

Cette première étape est poursuivie le temps nécessaire, dans des conditions de température, de pression et de débit des précurseurs choisies, pour que la couche primaire la présente une épaisseur, à l'issue de cette étape, inférieure à l'épaisseur critique à laquelle se forment des défauts pyramidaux. Comme on l'a vu, cette épaisseur critique est dépendante de la proportion d'indium dans la couche et l'épaisseur de la couche primaire est donc choisie dans la gamme précitée. Une fois cette épaisseur atteinte, on interrompt la fourniture du précurseur d'indium dans la chambre, puis, au cours d'une deuxième étape, on forme par épitaxie la couche secondaire 1b dans les gammes d'épaisseurs et de concentration précitées directement sur la couche primaire la.

Au cours de cette seconde étape, on fournit des précurseurs comprenant notamment un précurseur d'aluminium, comme cela est bien connu en soi. Cette étape est poursuivie dans les conditions de température, de pression et de débit des précurseurs pour former une couche secondaire 1b présentant une épaisseur inférieure à son épaisseur de relaxation.

On répète ensuite la première et la seconde étape qui viennent d'être décrites, jusqu'à obtenir une couche superficielle d'AlInGaN 1 d'épaisseur déterminée, composée d'une pluralité d'alternances.

La couche secondaire 1b d'AlGaN permet de stabiliser la couche primaire la d'InGaN et prévenir ou limiter, au cours de la croissance, l'émergence des défauts pyramidaux. Cet effet de stabilisation est favorisé en choisissant judicieusement les paramètres de croissance épitaxiale au cours des premières et secondes étapes.

Ainsi, on choisira les conditions de croissance épitaxiale de la deuxième étape (sa température, sa pression et les flux de précurseurs) pour qu'elles favorisent la désorption des espèces atomiques d'indium présentes à la surface de la couche primaire la. Il apparaît en effet que l'élimination de l'indium en surface de la couche primaire la, et sur une épaisseur proche de cette surface, favorise le phénomène de stabilisation conduisant à la défectivité réduite en défauts pyramidaux. Pour favoriser cela, on choisira préférentiellement les conditions de croissance pour que la première étape soit réalisée à une première température inférieure à la deuxième température de croissance choisie lors de la deuxième étape.

On fera également en sorte que la couche primaire la présente une rugosité de surface faible, cette faible rugosité limitant également l'apparition des défauts pyramidaux. Cela peut être obtenu en débutant la croissance de la couche secondaire 1b, par des conditions épitaxiales favorisant le lissage de la surface exposée de la couche primaire la. Pour obtenir cela, on peut choisir la pression de l'atmosphère de la chambre d'épitaxie au cours de la deuxième étape (la deuxième pression) pour qu'elle soit inférieure à la pression régnant dans la chambre au cours de la première étape (la première pression).

Comme on l'a vu précédemment, on peut également prévoir, au cours ou à l'issue de l'une des étapes du procédé, une étape additionnelle de traitement thermique d'homogénéisation des espèces atomiques constituant la couche primaire la et la couche secondaire 1b. Il peut s'agir d'un traitement thermique réalisé in situ dans le bâti 3 ou en dehors de celui-ci, dans un équipement de traitement thermique dédié. L'atmosphère du traitement thermique d'homogénéisation peut être une atmosphère neutre ou réductrice, en particulier sous ammoniac, la température comprise entre 800 et 1100°C, et sa durée supérieure à 1 heure.

Les premières et secondes étapes d'épitaxie peuvent être mises en œuvre par des techniques très conventionnelles de dépôt métalorganique en phase vapeur (MOCVD selon l'acronyme de la technologie la terminologie anglo-saxonne), ou par jets moléculaires (MBE). En MOCVD les précurseurs sont constitués de gaz circulant dans la chambre. En MBE, ces précurseurs sont extraits d'une source solide comme cela est bien connu en soi.

Outre la présence nécessaire des précurseurs en espèces atomiques d'aluminium, d'indium, de gallium et d'azote pouvant constiter les couches primaires et secondaires la, 1b, on peut prévoir de faire circuler d'autres gaz ou de prévoir d'autres sources solides dans la chambre, par exemple pour doper les couches, notamment avec du Si ou de Mg. En particulier, du silicium peut être intégré dans la couche primaire ou secondaire, dans une concentration comprise entre 10^17 et 10^19 par cm^3 pour introduire de la contrainte en tension dans les couches.

À titre d'exemple, on réalise un empilement de couches dans un bâti d'épitaxie MOCVD sur un substrat donneur 2 comprenant un film germe reporté en InGaN présentant une proportion d'indium de 0,05 et présentant un paramètre de maille dans le plan a de 3,205 Angström. Le film germe repose sur un support de saphir. L'empilement formant la couche superficielle 1 comprend une répétition de 8 alternances de films d'In_{0.08}Ga_{0.92}N (proportion d'indium de 0,08) de 90nm d'épaisseur et de 7 films d'Al_{0.03}Ga_{0.97}N (proportion d'aluminium de 0,03) de 9nm d'épaisseur. Cette répétition d'alternance conduit à former une couche semi-conductrice d'environ 800nm, équivalente à une couche homogène d'InGaN de la même épaisseur et présentant une concentration en indium de 7,4%.

Cette structure ne présentait aucune fissure, ni défaut pyramidal observé sur un champ de 1000 µm^2 d'un microscope à force atomique, ce qui vient à considérer qu'elle présentait une densité de défauts pyramidaux inférieure à 10^5 par cm^2. Elle était pseudomorphe, c'est-à-dire que le paramètre de maille du film germe dans le plan a été conservé au cours de la croissance.

L'épaisseur critique de formation de défauts pyramidaux pour des films d'In₀,₀₈Ga_{0,92}N est estimée inférieure à environ 150-200nm. L'épaisseur de la couche primaire la de chaque alternance est inférieure à cette valeur alors que l'épaisseur cumulée de la couche semi-conductrice est largement supérieure à cette valeur.

La contrainte biaxiale dans le plan des couches secondaires d'Al_{0.03}Ga_{0.97}N est d'environ 3,2 GPa en tension. L'épaisseur critique de fissuration est de 90 nm environ pour cette valeur de contrainte. L'épaisseur de chaque alternance d'Al_{0.03}Ga_{0.97}N est inférieure à cette valeur.

Les conditions de croissance des couches primaires d'InGaN (8% en Indium, 90nm d'épaisseur) étaient de 850°C, 300torr, un flux molaire de TMin de 105µmol/min, un rapport molaire TMIn/(TMin+TEGa) de 73%, un rapport molaire V/III de 3661, un mélange 70% NH3 / 30% N2/ 0% H2 dans l'arrivée des gaz hybrides (NH3,H2,N2) .

Les conditions de croissance des couches secondaires d'AlGaN (3% en Aluminium, 9nm) étaient de 950°C, 75torr, un flux molaire de TMGa 23µmol/min, un rapport molaire TMAl/(TMGa+TMAl) d'environ 3%, un rapport molaire V/III de 3400 et un mélange 10% NH3 / 80% N2/ 10% H2 dans l'arrivée de gaz hydrures.

La transition entre la première et la deuxième étape d'épitaxie se fait en maintenant un débit d'ammoniaque gazeux, mais sans débit d'organométalliques, et notamment en interrompant la circulation du gaz précurseur d'indium. La rampe de température, de pression, et de débit des gaz hydrures (NH3,H2,N2) dure 90sec puis est suivie d'une étape de stabilisation de 30sec.

À titre d'exemple complémentaire, l'empilement de couches suivant permet d'obtenir une couche superficielle 1 d'(Al,In,Ga)N d'épaisseur environ 250nm et de paramètre de maille « naturel » dans le plan égal à 3,238 Angström.
- Le substrat support est constitué d'un film germe 2a en GaN présentant une épaisseur d'environ 3 micromètres et présentant un paramètre de maille dans le plan a de 3,185 Angström. Le film germe a été formé par épitaxie sur un support 2b de saphir.
- On forme une répétition de 8 alternances de films la d'In_{0.15}Ga_{0.85}N (proportion d'indium de 0,15) de 30nm d'épaisseur et de 7 films 1b d'Al_{0.03}Ga_{0.97}N (proportion d'aluminium de 0,03) de 2nm d'épaisseur. Cette répétition d'alternance conduit à former une couche semi-conductrice d'environ 250nm.

En réalisant le substrat donneur selon le procédé qui vient d'être décrit, on peut former une couche superficielle d'AlInGaN épaisse, de l'ordre de 200 nm ou plus, et présentant un paramètre de maille naturel équivalent à celui d'une couche d'InGaN avec une forte proportion d'indium, par exemple de 6%, 10% voire même de 30%, sans que la couche superficielle ne présente une densité excessive de défauts pyramidaux.

Une telle couche semi-conductrice, après avoir été l'objet du procédé de relaxation décrit au début de cette description détaillée, est apte à former des îlots de croissance d'InₓAl_{y}Ga _{(1-x-y)}N présentant la même bonne qualité cristalline (par exemple une densité de défaut de type V-pits inférieure ou égale à 10^7 par cm^2), et avantageusement une épaisseur supérieure ou égale à 200nm et donc susceptible de favoriser le phénomène de relaxation. La proportion x d'indium peut être compris entre [0,1] et la proportion y d'aluminium peut être compris entre [0,1]. Avantageusement, la proportion x d'indium est comprise entre [0,1[ et la proportion y d'aluminium est compris entre ]0,1]. Les îlots de croissance peuvent être homogène en concentration d'aluminium et d'indium ou présenter l'alternance de couches primaires et secondaire la, 1b de la couche superficielle 1 d'où ils sont issus.

Le paramètre de maille de ces îlots de croissance en d'InₓAl_{y}Ga _{(1-x-y)}N peut ainsi être compris entre 0,321 et 0,337 nm. Comme on l'a vue, ces îlots peuvent être disposés sur un support final, au moins une couche diélectrique étant intercalée entre le support final et les d'îlots de croissance semi-conducteurs cristallins.

Bien entendu l'invention n'est pas limitée au mode de mise en œuvre décrit et on peut y apporter des variantes de réalisation sans sortir du cadre de l'invention tel que défini par les revendications.

## Revendications

1. Procédé de fabrication d'un substrat de croissance comprenant les étapes suivantes :
- préparer un substrat donneur (2) en formant une couche superficielle semi-conductrice cristalline (1) sur une couche germe (2a) d'un support (2b) ;
- reporter au moins une partie de la couche superficielle (1) sur un substrat de relaxation, en intercalant une couche de fluage entre le substrat donneur (2) et le substrat de relaxation pour former une structure de relaxation ;
- définir des îlots de croissance dans la couche superficielle (1) ;
- traiter thermiquement la structure de relaxation pour relaxer au moins en partie les îlots de croissance ;
le procédé étant **caractérisé en ce que** la préparation du substrat donneur (2) comprend la formation de la couche superficielle (1) comme une pluralité d'alternances d'une couche primaire (1a) d'InGaN et d'une couche secondaire (1b) d'AlGaN, la concentration en indium et l'épaisseur des couches primaires, la concentration en aluminium et l'épaisseur des couches secondaires étant choisies pour qu'une couche homogène d'AlInGaN équivalente, en concentration d'aluminium et d'indium, à la couche superficielle (1) présente un paramètre de maille naturel différent du paramètre de maille de la couche germe (2a).

2. Procédé de fabrication dans lequel chaque couche primaire (1a) présente une concentration en indium strictement supérieure à 0% et inférieure ou égale à 50 % et dont l'épaisseur est comprise entre 10 et 150 nm.

3. Procédé de fabrication selon la revendication précédente dans lequel chaque couche secondaire (1b) présente une concentration d'aluminium supérieure ou égale à 0% et inférieure ou égale 20% et dont l'épaisseur est comprise entre 2 et 15 nm.

4. Procédé de fabrication selon l'une des revendications précédentes dans lequel la pluralité d'alternances comprend entre 2 et 20 alternances.

5. Procédé de fabrication selon l'une des revendications précédentes dans lequel la couche superficielle (1) présente une épaisseur supérieure à 200nm.

6. Procédé de fabrication selon l'une des revendications précédentes comprenant un traitement thermique d'homogénéisation de la couche superficielle.

7. Procédé de fabrication selon l'une des revendications précédentes comprenant le report des îlots de croissance sur un support final, une couche diélectrique étant intercalée entre les îlots de croissance et le support final.

## Patentansprüche

1. Verfahren zum Herstellen eines Wachstumssubstrats, umfassend die folgenden Schritte:
- Gewinnen eines Donorsubstrats (2) durch Ausbilden einer kristallinen Halbleiteroberflächenschicht (1) auf einer Keimschicht (2a) eines Trägers (2b);
- Übertragen mindestens eines Teils der Oberflächenschicht (1) auf ein Entspannungssubstrat durch Einfügen einer Fließschicht zwischen dem Donorsubstrat (2) und dem Entspannungssubstrat zum Ausbilden einer Entspannungsstruktur;
- Definieren von Wachstumsinseln in der Oberflächenschicht (1);
- Wärmebehandeln der Entspannungsstruktur zum mindestens teilweisen Entspannen der Wachstumsinseln;
wobei das Verfahren **dadurch gekennzeichnet ist, dass** das Gewinnen des Donatorsubstrats (2) das Ausbilden der Oberflächenschicht (1) als eine Vielzahl von Abwechslungen einer Primärschicht (1a) aus InGaN und einer Sekundärschicht (1b) aus AIGaN umfasst, die Konzentration von Indium und die Dicke der Primärschichten, die Konzentration von Aluminium und die Dicke der Sekundärschichten gewählt sind, damit eine homogene Schicht aus AlInGaN, die in Konzentration von Aluminium und von Indium der Oberflächenschicht (1) gleichwertig ist, einen natürlichen Gitterparameter aufweist, der sich von dem Gitterparameter der Keimschicht (2a) unterscheidet.

2. Herstellungsverfahren, wobei jede Primärschicht (1a) eine Indiumkonzentration streng über 0 % und unter oder gleich 50 % aufweist und deren Dicke zwischen 10 und 150 nm liegt.

3. Herstellungsverfahren nach dem vorstehenden Anspruch, wobei jede Sekundärschicht (1b) eine Aluminiumkonzentration über oder gleich 0 % und unter oder gleich 20 % aufweist und deren Dicke zwischen 2 und 15 nm liegt.

4. Herstellungsverfahren nach einem der vorstehenden Ansprüche, wobei die Vielzahl von Abwechslungen zwischen 2 und 20 Abwechslungen umfasst.

5. Herstellungsverfahren nach einem der vorstehenden Ansprüche, wobei die Oberflächenschicht (1) eine Dicke über 200 nm aufweist.

6. Herstellungsverfahren nach einem der vorstehenden Ansprüche, umfassend ein Wärmebehandeln zum Homogenisieren der Oberflächenschicht.

7. Herstellungsverfahren nach einem der vorstehenden Ansprüche, umfassend das Übertragen der Wachstumsinseln auf einen endgültigen Träger, wobei eine Sperrschicht zwischen die Wachstumsinseln und den endgültigen Träger eingefügt wird.

## Claims

1. Method for producing a growth substrate comprising the following steps:
- preparing a donor substrate (2) by forming a crystalline semiconductor surface layer (1) on a seed layer (2a) of a support (2b);
- transferring at least part of the surface layer (1) onto a relaxation substrate, and inserting a creep layer between the donor substrate (2) and the relaxation substrate to form a relaxation structure;
- defining growth islands in the surface layer (1);
- heat treating the relaxation structure to at least partially relax the growth islands;
the method being **characterized in that** the preparation of the donor substrate (2) comprises the formation of the surface layer (1) as a plurality of alternations of a primary layer (1a) of InGaN and of a secondary layer (1b) of AIGaN, the concentration of indium and the thickness of the primary layers and the concentration of aluminum and the thickness of the secondary layers being selected so that a homogeneous layer of AlInGaN which is equivalent, in aluminum and indium concentrations, to the surface layer (1) has a natural lattice parameter different from the lattice parameter of the seed layer (2a).

2. Production method wherein each primary layer (1a) has an indium concentration strictly greater than 0% and less than or equal to 50% and the thickness thereof is between 10 and 150 nm.

3. Production method according to the preceding claim, wherein each secondary layer (1b) has an aluminum concentration greater than or equal to 0% and less than or equal to 20% and the thickness thereof is between 2 and 15 nm.

4. Production method according to any of the preceding claims, wherein the plurality of alternations comprises between 2 and 20 alternations.

5. Production method according to any of the preceding claims, wherein the surface layer (1) has a thickness greater than 200 nm.

6. Production method according to any of the preceding claims, comprising a heat treatment for homogenizing the surface layer.

7. Production method according to any of the preceding claims, comprising the transfer of the growth islands onto a final support, a dielectric layer being interposed between the growth islands and the final support.
